# EUROPEAN PATENT APPLICATION

(11) **EP 4 489 059 A1**
(43) Date of publication of application: **08.01.2025**
(21) Application number: 22929732.0
(22) Date of filing: 02.03.2022
(51) Int. Cl.: H01L 21/66

(54) **SEMICONDUCTOR TEST RESULT ANALYZING DEVICE, SEMICONDUCTOR TEST RESULT ANALYZING METHOD AND COMPUTER PROGRAM**

(71) Applicant: ADVANTEST CORPORATION, Chiyoda-ku Tokyo 100-0005 (JP)
(72) Inventor: IKEDA, Kosuke, Tokyo 100-0005 (JP); SUGIMURA, Hajime, Tokyo 100-0005 (JP)
(74) Representative: Meissner Bolte Partnerschaft mbB
(86) International application number: PCT/JP2022/008767
(87) International publication number: WO 2023/166584

(57) **Abstract**

A condition data acquirer 30 acquires first data (condition data) of a plurality of items related to a test process of a plurality of semiconductor chips. A test result acquirer 32 acquires second data (test result data) indicating test results of the plurality of semiconductor chips in the test process. A decision tree generator 34 generates a decision tree with each item of the condition data as a feature amount and the test result data as a target value. An analysis result outputter 40 outputs, as an item having a large influence on the test results, information of a feature amount having a relatively high importance in the decision tree.

## Description

### TECHNICAL FIELD

The present disclosure relates to a semiconductor test result analysis device, a semiconductor test result analysis method, and a computer program.

### BACKGROUND ART

In a test process of a semiconductor chip, a problem that a normal chip is determined to be a defective product (hereinafter, also referred to as an "inspection defect") may occur due to a test environment (for example, a defect of a probe card or the like). Conventionally, in a case where there is a suspicion of occurrence of the inspection defect, a person analyzes various data related to the test process of the semiconductor chip, and estimates the reason why the semiconductor chip has been determined to be a defective product.

Patent Literature 1 discloses technology for creating a decision tree with the presence or absence of a defect of a solar cell as an objective variable and a plurality of types of manufacturing conditions at the time of manufacturing the solar cell as a plurality of types of objective variables, and displaying a classification result of quality data including the created decision tree and the manufacturing conditions used for classifying the quality data of the solar cell.

### RELATED-ART LITERATURE

### PATENT LITERATURE

Patent Literature 1: JP 2020-123274

### SUMMARY OF INVENTION

### TECHNICAL PROBLEM

A heavy burden has been placed on an analyst who analyzes various data related to the test process of the semiconductor chip and estimates the reason why the semiconductor chip has been determined to be a defective product. The technology disclosed in Patent Literature 1 described above cannot sufficiently support the work of the analyst who estimates the reason why the semiconductor chip has been determined to be a defective product.

The present disclosure has been made in such a situation, and one exemplary object thereof is to provide technology for supporting estimation of the reason why a semiconductor chip has been determined to be a defective product.

### SOLUTION TO PROBLEM

In order to solve the above problem, a semiconductor test result analysis device according to one aspect of the present disclosure includes: a first acquirer that acquires first data of a plurality of items related to a test process of a plurality of semiconductor chips; a second acquirer that acquires second data indicating test results of the plurality of semiconductor chips in the test process; a decision tree generator that generates a decision tree with each item of the first data as a feature amount and the second data as a target value; and an outputter that outputs, as an item having a large influence on the test results, information of a feature amount having a relatively high importance in the decision tree.

Another aspect of the present disclosure is a semiconductor test result analysis method. This method includes: a step of causing a computer to acquire first data of a plurality of items related to a test process of a plurality of semiconductor chips; a step of causing the computer to acquire second data indicating test results of the plurality of semiconductor chips in the test process; a step of causing the computer to generate a decision tree with each item of the first data as a feature amount and the second data as a target value; and a step of causing the computer to output, as an item having a large influence on the test results, information of a feature amount having a relatively high importance in the decision tree.

Note that arbitrary combinations of the above components and conversions of components and expressions between a system, a program, a recording medium storing a program, and the like are also effective as aspects of the present disclosure.

### ADVANTAGEOUS EFFECTS OF INVENTION

According to one aspect of the present disclosure, it is possible to support estimation of the reason why a semiconductor chip has been determined to be a defective product.

### BRIEF DESCRIPTION OF DRAWINGS

- [Fig. 1] Fig. 1: is a diagram illustrating a configuration of an analysis system according to an embodiment.
- [Fig. 2] Fig. 2: is a block diagram illustrating functional blocks of an analysis device in Fig. 1.
- [Fig. 3] Fig. 3: is a flowchart illustrating an operation of the analysis device.
- [Fig. 4] Fig. 4: is a diagram illustrating an example of a fail factor analysis screen.
- [Fig. 5] Fig. 5: is a diagram illustrating an example of a graph image of Fig. 4.

### DESCRIPTION OF EMBODIMENTS

An outline of an embodiment will be described. An analysis system according to the embodiment creates a decision tree with a plurality of items related to a test process of a plurality of semiconductor chips as feature amounts and test results of the plurality of semiconductor chips as target values. The analysis system according to the embodiment provides information of a feature amount having a relatively high importance in the created decision tree to an analyst as an item having a large influence on the test result. In addition, the analysis system according to the embodiment further provides the analyst with a graph image illustrating a correspondence relation between the feature amounts of the plurality of items used to generate the decision tree and the test results of the plurality of semiconductor chips, together with the information of the item having a large influence on the test result, which is derived from the decision tree.

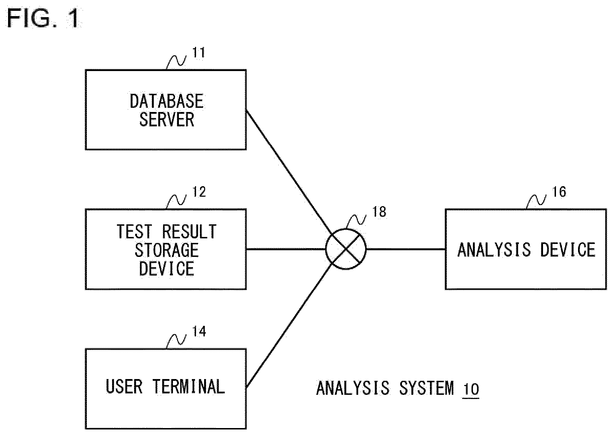

Details of the embodiment will be described. Fig. 1 illustrates a configuration of an analysis system 10 according to the embodiment. The analysis system 10 is an information processing system including a database server 11, a test result storage device 12, a user terminal 14, and an analysis device 16. These devices are connected via a communication network 18 including a LAN, a WAN, the Internet, and the like.

The database server 11 is a device that stores first data (hereinafter, referred to as "condition data") of a plurality of items related to a manufacturing process and a test process of each of a plurality of semiconductor chips. The condition data includes an item whose value is a discrete value. The discrete value includes a value that is not a numerical value representing a quantity or a magnitude. The item whose value is the discrete value includes identification information such as an ID, and includes, for example, an ID of a jig, an ID of an operator, and the like.

Specifically, the condition data includes at least one of (1) a pushing amount of a probe card into a semiconductor chip, (2) an ID of a jig, (3) an ID of an operator in charge of a test, (4) an ID of a semiconductor test device (tester), (5) an ID of a lot of the semiconductor chip, (6) the coordinates of the semiconductor chip on a wafer, and (7) the number of tests. The condition data of the embodiment includes all the above items (1) to (7). The jig includes, for example, a probe card and/or a performance board. Note that the condition data may include items other than the above seven items. In addition, a user may select an item to be used for analysis from a plurality of items including the above seven items.

The test result storage device 12 stores second data (hereinafter, referred to as "test result data") indicating the test result of the semiconductor chip in the test process. The test result data includes, for example, data indicating whether each of the plurality of semiconductor chips is determined to be a non-defective product (pass) or a defective product (fail) in the test. A failure in the test result is also referred to as fail. In addition, the test result data includes data indicating pass/fail for each category determined in advance as the test result.

The category can be said to be a section in which a specific type of fail occurs, and can also be said to be a soft bin (type of fail). For example, the category may include a section in which a soft bin number 1, that is, a first fail occurs, and a section in which a soft bin number 2, that is, a second fail occurs. Further, the test result data may include at least one of a hard bin (that is, an overall test result), a soft bin, an ID of a failed test.

The user terminal 14 is an information processing device operated by an analyst (hereinafter, also referred to as a "user") who performs analysis work of the reason why the semiconductor chip has been determined to be a defective product. The user terminal 14 may be a laptop computer, a tablet terminal, or a smartphone. The user terminal 14 includes a display or is connected to an external display.

The analysis device 16 is an information processing device that analyzes various condition data and test result data and generates information for supporting estimation of the reason why the semiconductor chip has been determined to be a defective product. The analysis device 16 can also be said to be a semiconductor test result analysis device.

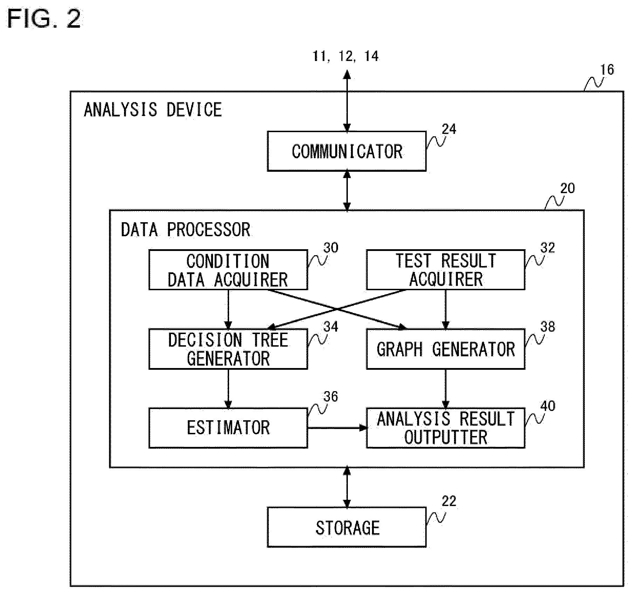

Fig. 2 is a block diagram illustrating functional blocks of the analysis device 16 in Fig. 1. Each block illustrated in the block diagram of the present disclosure can be realized by an element including a CPU or a memory of a computer or a mechanical device in terms of hardware, and can be realized by a computer program or the like in terms of software. However, here, functional blocks realized by cooperation of these are illustrated. Those skilled in the art will understand that these functional blocks can be realized in various forms by combining hardware and software.

The analysis device 16 includes a data processor 20, a storage 22, and a communicator 24. The data processor 20 executes various data processing. The storage 22 stores data to be referred to or updated by the data processor 20. The communicator 24 communicates with an external device in accordance with a predetermined communication protocol. The data processor 20 transmits and receives data to and from the database server 11, the test result storage device 12, and the user terminal 14 via the communicator 24.

The data processor 20 includes a condition data acquirer 30, a test result acquirer 32, a decision tree generator 34, an estimator 36, a graph generator 38, and an analysis result outputter 40. Functions of the plurality of functional blocks included in the data processor 20 may be implemented in a computer program, and the computer program may be installed in a storage of the analysis device 16. A processor (CPU or the like) of the analysis device 16 may perform the functions of the plurality of functional blocks by reading and executing the computer program in a main memory.

The condition data acquirer 30 acquires, as a first acquirer, the condition data stored in the database server 11 from the database server 11. The test result acquirer 32 acquires, as a second acquirer, the test result data stored in the test result storage device 12 from the test result storage device 12.

The decision tree generator 34 generates a decision tree with each item of the condition data acquired by the condition data acquirer 30 as a feature amount and the test result data acquired by the test result acquirer 32 as a target value. The estimator 36 estimates a feature amount (that is, an item of the condition data) having a relatively high importance in the decision tree generated by the decision tree generator 34.

In a region in which a plurality of items of the condition data acquired by the condition data acquirer 30 are arranged on one axis and a plurality of values of the respective items is arranged in a direction orthogonal (including substantially orthogonal) to the axis, the graph generator 38 generates a graph image in which corresponding values are connected by lines over the plurality of items of the condition data for each group of a plurality of semiconductor chips having the same test environment. The graph generator 38 changes a form of the lines for each group in the graph image according to a ratio of the semiconductor chips whose test results have been failed in each group.

The analysis result outputter 40 transmits data of an analysis result screen (a fail factor analysis screen to be described later) including the estimation result by the estimator 36 and the graph image generated by the graph generator 38 to the user terminal 14. On the analysis result screen, the analysis result outputter 40 sets, as an item having a large influence on the test result, information of a feature amount estimated by the estimator 36 and having a relatively high importance in the decision tree.

An operation of the analysis system 10 having the above configuration will be described.

Condition data related to a manufacturing process and a test process of each of the plurality of semiconductor chips is registered in the database server 11 from a device (not illustrated) that manages the manufacturing process or the test process. In addition, test result data of each of the plurality of semiconductor chips is registered in the test result storage device 12 from a semiconductor test device or the like (not illustrated).

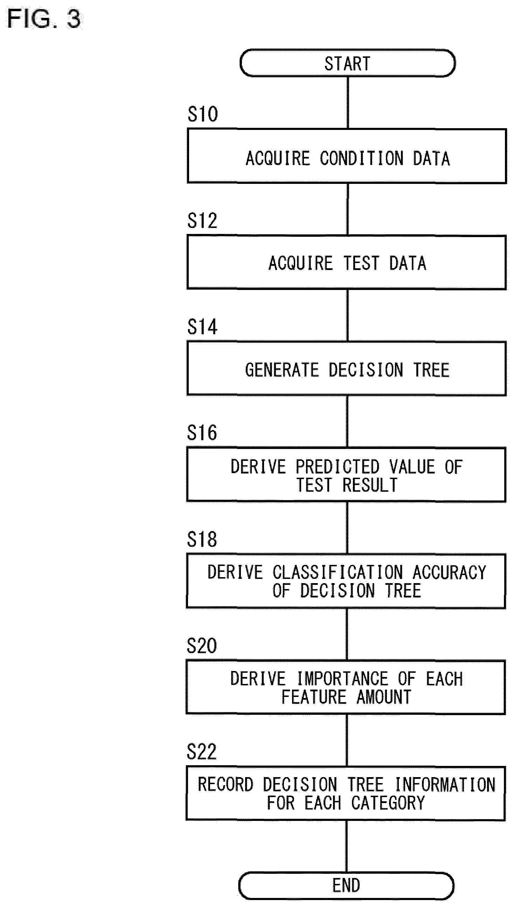

Fig. 3 is a flowchart illustrating the operation of the analysis device 16. The condition data acquirer 30 of the analysis device 16 acquires condition data from the database server 11 and stores the condition data in the storage 22 (S10). The test result acquirer 32 of the analysis device 16 acquires test data (performance value) from the test result storage device 12 and stores the test data in the storage 22 (S12). The decision tree generator 34 of the analysis device 16 generates a gradient boosting decision tree based on learning condition data and learning test result data by using a library of gradient boosting machine learning frameworks based on a decision tree algorithm (S14).

The estimator 36 of the analysis device 16 inputs the condition data for the test to the decision tree and derives a predicted value of the test result (S16). The estimator 36 derives the accuracy of classification by the decision tree based on the predicted value of the test result and the performance value of the test result using Area Under the Curve (AUC) (S18). The closer the AUC score is to 1, the higher the accuracy of classification. In addition, the estimator 36 derives an importance of each feature amount (that is, each item of the condition data) in the decision tree by using a feature_importance function (S20).

The decision tree generator 34 according to the embodiment generates a decision tree for each category by using the condition data of each of the plurality of semiconductor chips and the test result data for each category. In other words, the decision tree generator 34 generates a plurality of decision trees corresponding to a plurality of categories. The estimator 36 derives the accuracy of classification for each of the plurality of decision trees corresponding to the plurality of categories, and further derives an importance of each feature amount. Hereinafter, information indicating the accuracy of classification in the decision tree and information indicating the importance of each feature amount are also collectively referred to as decision tree information. The estimator 36 stores the decision tree information of each of the plurality of decision trees corresponding to the plurality of categories in the storage 22 (S22).

The graph generator 38 of the analysis device 16 generates a graph image for each category using the condition data of each of the plurality of semiconductor chips and the test result data for each category. In other words, the graph generator 38 generates a plurality of graph images corresponding to a plurality of categories. The graph generator 38 stores the plurality of graph images in the storage 22.

The user terminal 14 transmits analysis request data including information of the category designated by the user to the analysis device 16. When the analysis request data is received, the analysis result outputter 40 generates data of the fail factor analysis screen based on the decision tree information and the graph image corresponding to the category designated by the analysis request data stored in the storage 22. The analysis result outputter 40 transmits the generated data of the fail factor analysis screen to the user terminal 14. The user terminal 14 causes the display to display the analysis result screen provided from the analysis device 16 (analysis result outputter 40).

Note that the analysis device 16 may have a function of a web server. In this case, the analysis result outputter 40 may transmit web page data of the analysis result screen to the user terminal 14 as a response to an HTTP request including the analysis request data. A web browser of the user terminal 14 may cause the display to display the web page of the analysis result screen.

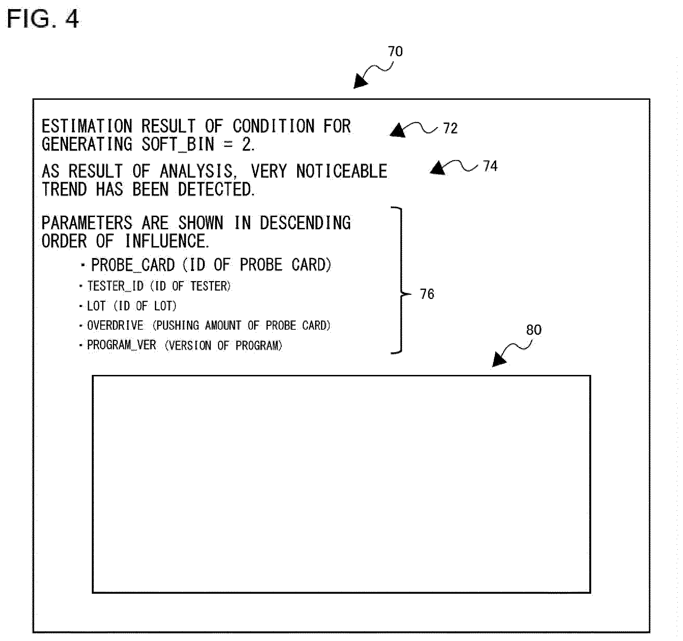

Fig. 4 illustrates an example of a fail factor analysis screen 70. The analysis result outputter 40 sets category information 72, accuracy information 74, influence information 76, and a graph image 80 on the fail factor analysis screen 70. The analysis result outputter 40 sets information of a category (hereinafter, also referred to as a "target category") designated by the user as the category information 72. The category information 72 in Fig. 4 indicates that the fail factor analysis screen 70 is content related to a category identified by the soft bin number 2.

The analysis result outputter 40 sets, as the accuracy information 74, information based on the accuracy of classification in the decision tree of the target category stored in the storage 22. The accuracy information 74 can also be said to be information indicating a level of the accuracy of classification in the decision tree. The accuracy information 74 in Fig. 4 indicates that the accuracy of classification in the decision tree is high, that is, the AUC score is close to 1. Note that the analysis result outputter 40 may set an index value of the accuracy of classification in the decision tree as the accuracy information 74, and may set the AUC score as the accuracy information 74, for example.

The analysis result outputter 40 sets, as the influence information 76, information of a feature amount having a relatively high importance in the decision tree of the target category stored in the storage 22. In the influence information 76 of Fig. 4, feature amounts of the top five in descending order of importance are illustrated. "PROBE_CARD" is a unique ID of a physical probe card, and can also be said to be a jig ID. "TESTER_ID" is an ID of the tester. "LOT" is an ID of a lot of semiconductor chips. "OVERDRIVE" is a setting value of a pushing amount of the probe card. "PROGRAM_VER" is a version number of a program (for example, a semiconductor test program).

As described above, according to the analysis device 16 of the embodiment, the item of the condition data having a large influence on the test results of the plurality of semiconductor chips is automatically estimated, and the influence information 76 indicating the estimation result is provided to the user. As a result, it is possible to reduce the burden of the analysis work of the test result by the user, and it is also possible to reduce the variations in the estimation accuracy of the fail reason depending on the skill of the user. Further, the analysis device 16 can support the user's determination regarding the validity of the influence information 76 by further providing the accuracy information 74 of the decision tree.

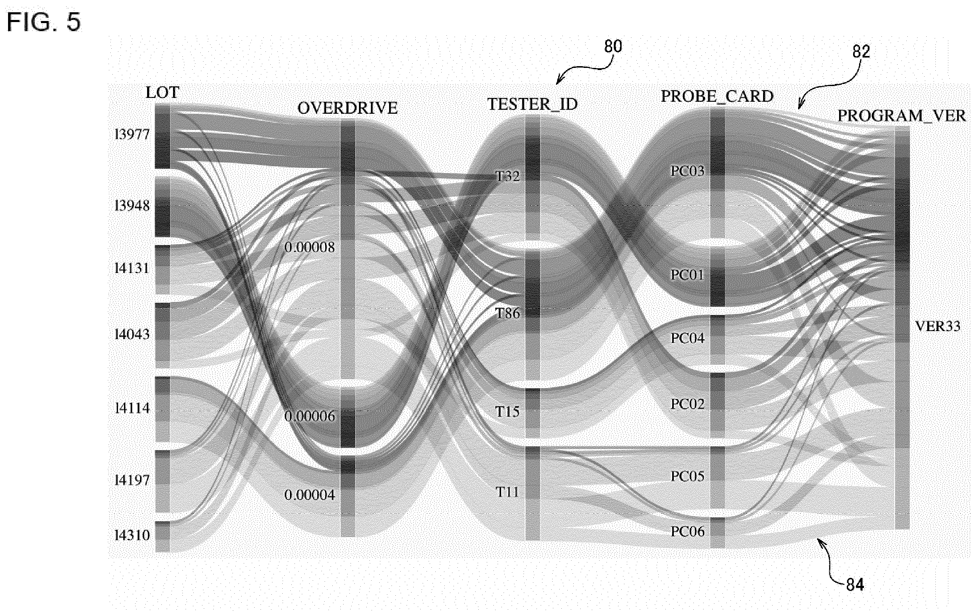

Fig. 5 illustrates an example of the graph image 80 of Fig. 4. A plurality of items of condition data are set on a horizontal axis of the graph image 80. In the graph image 80 of Fig. 5, LOT (an ID of a lot of semiconductor chips), OVERDRIVE (a setting value of a pushing amount of a probe card), TESTER_ID (an ID of a tester), PROBE_CARD (an ID of the probe card), and PROGRAM_VER (a version number of a program) are arranged from the left. Values of the respective items of the condition data are arranged in a vertical direction orthogonal to the horizontal axis of the graph image 80. For example, in the condition data LOT, a plurality of lot numbers, for example, "13977", "13948", "14131", ··· are vertically arranged.

The graph generator 38 sets a line (hereinafter, also referred to as a "group line") in the graph image 80 in units of groups of a plurality of semiconductor chips in the same test environment. The graph generator 38 sets a group line connecting corresponding values over a plurality of items of condition data for each group of semiconductor chips. The group in the embodiment includes a plurality of semiconductor chips at the same site on the same wafer.

The graph generator 38 changes a form of each group line according to a ratio of semiconductor chips whose test results have been failed in each group, specifically, a ratio of semiconductor chips in which the fail of the target category has occurred. That is, when the graph image 80 of the certain category is generated, the graph generator 38 changes the form of each group line according to a ratio of semiconductor chips whose test results of the category have been failed in each group. The graph generator 38 sets a group line (defective group line 82) of a group having a relatively high ratio of fails in a form in which the visibility is more enhanced than a group line (normal group line 84) of a group having a relatively low ratio of fails. In the form in which the visibility is enhanced, for example, a conspicuous color may be set, or a line width may be increased.

In the embodiment, the graph generator 38 changes the color of the group line according to the ratio of fails. The graph generator 38 strengthens a red component of the group line and sets the color of the group line to dark red as the ratio of semiconductor chips in which the fail of the target category has occurred increases. For example, the defective group line 82 is a dark red group line. On the other hand, the graph generator 38 weakens the red component of the group line and causes the color of the group line to be closer to white as the ratio of semiconductor chips in which the fail of the target category has occurred decreases. For example, the normal group line 84 is a white group line.

When a plurality of group lines is arranged in a place of a specific value of specific condition data (for example, a region of "PC03" of condition data PROBE_CARD), the graph generator 38 arranges the plurality of group lines in order of the magnitude of an occurrence ratio of fails of the target category. The graph generator 38 of the embodiment arranges a group line of a group in which the occurrence ratio of the fails of the target category is higher (that is, a group line in which the red component is stronger) at an upper position.

According to the analysis device 16 of the embodiment, by providing the graph image 80, it is possible to support the estimation of the fail reason by the user. For example, in a case where the red group lines are concentrated in the place of the specific value of the specific condition data in the graph image 80, the test environment (also referred to as a condition) indicated by the value of the corresponding item can be estimated as a factor having a high influence on the fail. For example, in the graph image 80 of Fig. 5, "13977" and "13948" of the item LOT, "0.00006" of the item OVERDRIVE, and "PC01" of the item PROBE_CARD can be estimated as factors having a high influence on the fail.

In addition, the analysis device 16 provides the fail factor analysis screen 70 including both the influence information 76 and the graph image 80. As a result, the validity of the influence information 76 derived from the decision tree can be confirmed by the graph image 80. Conversely, validity of an item having a large influence on the test result read from the graph image 80 can be confirmed by the influence information 76.

On the fail factor analysis screen 70, the user can select a desired target category. When the user changes the target category, the user terminal 14 transmits analysis request data designating the changed target category to the analysis device 16. The analysis result outputter 40 of the analysis device 16 generates a new fail factor analysis screen 70 based on the decision tree information and the graph image associated with the changed target category stored in the storage 22, and provides the new fail factor analysis screen 70 to the user terminal 14.

Note that the target category may be automatically determined. For example, the target category may be determined based on an occurrence ratio (fail ratio) for each category in test results of the past several tens of lots, and a category having a relatively high fail ratio may be selected as the target category. In addition, the target category may be determined by outlier determination using a standard deviation based on the occurrence ratio (fail ratio) for each category.

In addition, on the fail factor analysis screen 70, the user can select an item of condition data arranged on the horizontal axis of the graph image 80. The user terminal 14 transmits, to the analysis device 16, analysis request data designating an item of condition data to be displayed set or changed by the user. The graph generator 38 of the analysis device 16 generates the graph image 80 in which the item of the condition data to be displayed designated by the analysis request data is arranged on the horizontal axis. The analysis result outputter 40 of the analysis device 16 provides the user terminal 14 with the fail factor analysis screen 70 including the graph image 80 generated by the estimator 36.

The present disclosure has been described based on the embodiments. The embodiments are merely examples, and it is understood by those skilled in the art that various modifications can be made in the combination of the respective components or the respective processes of the embodiments, and that the modifications are also within the scope of the present disclosure.

A modification will be described. The graph generator 38 of the analysis device 16 may automatically set an item corresponding to a feature amount having a relatively high importance in a decision tree of a certain category as an item of condition data to be set in the graph image 80 of the category. For example, the graph generator 38 may set, on the horizontal axis of the graph image 80, an item of condition data whose importance in the decision tree is within a predetermined rank (for example, up to the top 5). As a result, it is possible to automatically provide the graph image 80 capable of efficiently confirming the validity of the influence information 76 derived from the decision tree.

Another modification will be described. The graph generator 38 of the analysis device 16 may generate the graph image 80 in which a group line corresponding to a group in which a ratio of semiconductor chips in which the test results have been fail is equal to or more than a predetermined threshold is set in a form different from that of a group line corresponding to a group in which a ratio of semiconductor chips in which test results have been fail is less than the threshold. The graph generator 38 may set the former group line in a form in which the visibility is higher than that of the latter group line. For example, the former group line may be set to red, and the latter group line may be set to white. In addition, the former group line may be set to a thick line, and the latter group line may be set to a thin line. The above threshold may be set to an appropriate value based on knowledge of the developer or an experiment using the analysis system 10.

Still another modification will be described. The estimator 36 of the above embodiment estimates the importance of each feature amount in the decision tree using a feature_importance function. As a modification, the estimator 36 may estimate the importance of each feature amount in the decision tree using another function or method. For example, the estimator 36 may derive the importance of each feature amount in the decision tree using a permutation importance function.

Still another modification will be described. The plurality of functional blocks included in the analysis device 16 in the above embodiment may be implemented in a distributed manner in a plurality of information processing devices (which may include a cloud service). In this case, processing similar to the processing of the analysis device 16 in the above embodiment may be realized by the plurality of information processing devices cooperating as a system.

Any combination of the above-described embodiments and modifications is also useful as an embodiment of the present disclosure. The new embodiment generated by the combination has the effect of each of the combined embodiments and modifications. In addition, it is understood by those skilled in the art that the functions to be performed by the components described in the claims are realized by single bodies of the components described in the embodiments and the modifications or by cooperation of the components.

The technologies described in the embodiments and the modifications may be specified by aspects described in the following items.

### [Item 1-1]

A semiconductor test result analysis device including:
- a first acquirer structured to acquire first data of a plurality of items related to a test process of a plurality of semiconductor chips;
- a second acquirer structured to acquire second data indicating test results of the plurality of semiconductor chips in the test process;
- a decision tree generator structured to generate a decision tree with each item of the first data as a feature amount and the second data as a target value; and
- an outputter structured to output, as an item having a large influence on the test results, information of a feature amount having a relatively high importance in the decision tree.

According to this semiconductor test result analysis device, it is possible to automatically estimate an item (also referred to as a "parameter") of the first data having a large influence on the test results of the plurality of semiconductor chips, and to reduce a burden of analysis work of the test results by a user. In addition, it is possible to reduce variations in the estimation accuracy of the fail reason depending on the skill of the user.

### [Item 1-2]

The semiconductor test result analysis device according to item 1-1, wherein the first data includes an item whose value is a discrete value.

According to this semiconductor test result analysis device, since the decision tree is used, an item having a large influence on the test results can be accurately estimated even when the discrete value is included in the item of the first data.

### [Item 1-3]

The semiconductor test result analysis device according to item 1-1 or 1-2, wherein the first data includes at least one of (1) a pushing amount of a probe card into each of the semiconductor chips, (2) a jig ID, (3) an ID of an operator in charge of a test, (4) an ID of a semiconductor test device, (5) a lot ID of each of the semiconductor chips, (6) coordinates of each of the semiconductor chips on a wafer, and (7) the number of tests.

According to this semiconductor test result analysis device, it is possible to estimate influences of various parameters related to the test process of the semiconductor chips on the test results.

### [Item 1-4]

The semiconductor test result analysis device according to any one of items 1-1 to 1-3, wherein the second data indicates pass/fail for each category determined in advance as the test results, the decision tree generator generates a decision tree for each category, and the outputter outputs information of a feature amount having a relatively high importance in the decision tree for each category.

According to this semiconductor test result analysis device, it is possible to present, to the user, an item having a large influence on pass/fail for each category determined to be fail.

### [Item 1-5]

The semiconductor test result analysis device according to any one of items 1-1 to 1-4, wherein the outputter outputs information based on accuracy of classification by the decision tree together with the information of a feature amount having a relatively high importance in the decision tree.

According to this semiconductor test result analysis device, validity of content presented as an item having a large influence on the test results can be presented easily to the user.

### [Item 1-6]

A semiconductor test result analysis method including:
- a step of causing a computer to acquire first data of a plurality of items related to a test process of a plurality of semiconductor chips;
- a step of causing the computer to acquire second data indicating test results of the plurality of semiconductor chips in the test process;
- a step of causing the computer to generate a decision tree with each item of the first data as a feature amount and the second data as a target value; and
- a step of causing the computer to output, as an item having a large influence on the test results, information of a feature amount having a relatively high importance in the decision tree.

According to this semiconductor test result analysis method, it is possible to automatically estimate an item (also referred to as a "parameter") of the first data having a large influence on the test results of the plurality of semiconductor chips, and to reduce a burden of analysis work of the test results by the user. In addition, it is possible to reduce variations in the accuracy of reason estimation depending on the skill of the user.

### [Item 1-7]

A computer program for causing a computer to realize:
- a function of acquiring first data of a plurality of items related to a test process of a plurality of semiconductor chips;
- a function of acquiring second data indicating test results of the plurality of semiconductor chips in the test process;
- a function of generating a decision tree with each item of the first data as a feature amount and the second data as a target value; and
- a function of outputting, as an item having a large influence on the test results, information of a feature amount having a relatively high importance in the decision tree.

According to this computer program, it is possible to realize a computer that automatically estimates an item (also referred to as a "parameter") of the first data having a large influence on the test results of the plurality of semiconductor chips, and to reduce a burden of analysis work of the test results by the user. In addition, it is possible to reduce variations in the accuracy of reason estimation depending on the skill of the user.

### [Item 2-1]

A semiconductor test result analysis device including:
- a first acquirer structured to acquire first data of a plurality of items related to a test process of a plurality of semiconductor chips;
- a second acquirer structured to acquire second data indicating test results of the plurality of semiconductor chips in the test process; and
- a graph generator structured to generate, in a region in which a plurality of items of the first data is arranged on one axis and a plurality of values of the respective items is arranged in a direction orthogonal to the axis, a graph image in which corresponding values are connected by lines over the plurality of items for each group of a plurality of semiconductor chips having the same test environment,
wherein the graph generator changes a form of the lines for each group in the graph image according to a ratio of semiconductor chips whose test results have been failed in each group.

According to this semiconductor test result analysis device, when the semiconductor chips whose test results are fail are generated, analysis of a factor thereof can be supported. For example, in the graph image, in a case where lines of groups in which the ratio of semiconductor chips whose test results have been fail is high are concentrated on a specific value of a specific item, a test environment (also referred to as a condition) indicated by the value of the corresponding item can be estimated as a factor having a high influence on the fail.

### [Item 2-2]

The semiconductor test result analysis device according to item 2-1, wherein the first data includes at least one of (1) a pushing amount of a probe card into each of the semiconductor chips, (2) a jig ID, (3) an ID of an operator in charge of a test, (4) an ID of a semiconductor test device, (5) a lot ID of each of the semiconductor chips, (6) coordinates of each of the semiconductor chips on a wafer, and (7) the number of tests.

According to this semiconductor test result analysis device, it is possible to easily present a parameter having a high influence on the fail among various parameters related to the test process of the semiconductor chips.

### [Item 2-3]

The semiconductor test result analysis device according to item 2-1 or 2-2, wherein the second data indicates pass/fail for each category determined in advance as the test results, the graph generator generates a graph image for each category, and the graph generator changes a form of a line for each group in a graph image of a certain category according to a ratio of semiconductor chips whose test results of the corresponding category have been failed in each group.

According to this semiconductor test result analysis device, it is possible to support the analysis of a factor of the fail of the test result for each category.

### [Item 2-4]

The semiconductor test result analysis device according to any one of items 2-1 to 2-3, further including:
- a decision tree generator structured to generate a decision tree with each item of the first data as a feature amount and the second data as a target value; and
- an outputter structured to cause information of a feature amount having a relatively high importance in the decision tree to be displayed as an item having a large influence on the test results together with the graph image.

According to this semiconductor test result analysis device, it is possible to provide analysis result information that enables validity of the item having a large influence on the test result derived from the decision tree to be confirmed by the graph image, or it is possible to provide analysis result information that enables validity of the item having a large influence on the test result read from the graph image to be confirmed by information derived from the decision tree.

### [Item 2-5]

The semiconductor test result analysis device according to item 2-4, wherein the graph generator automatically sets an item corresponding to the feature amount having a relatively high importance in the decision tree as an item of the first data set in the graph image.

According to this semiconductor test result analysis device, it is possible to automatically generate a graph image capable of efficiently confirming the validity of the item having a large influence on the test result derived from the decision tree.

### [Item 2-6]

A semiconductor test result analysis method including:
- a step of causing a computer to acquire first data of a plurality of items related to a test process of a plurality of semiconductor chips;
- a step of causing the computer to acquire second data indicating test results of the plurality of semiconductor chips in the test process; and
- a step of causing the computer to generate, in a region in which a plurality of items of the first data is arranged on one axis and a plurality of values of the respective items is arranged in a direction orthogonal to the axis, a graph image in which corresponding values are connected by lines over the plurality of items for each group of a plurality of semiconductor chips having the same test environment,
wherein the generating step changes a form of the lines for each group in the graph image according to a ratio of semiconductor chips whose test results have been failed in each group.

According to this semiconductor test result analysis method, when the semiconductor chips whose test results are fail are generated, analysis of a factor thereof can be supported. For example, in the graph image, in a case where lines of groups in which the ratio of semiconductor chips whose test results have been fail is high are concentrated on a specific value of a specific item, the item can be estimated as a factor having a high influence on the fail.

### [Item 2-7]

A computer program for causing a computer to realize:
- a function of acquiring first data of a plurality of items related to a test process of a plurality of semiconductor chips;
- a function of acquiring second data indicating test results of the plurality of semiconductor chips in the test process; and
- a function of generating, in a region in which a plurality of items of the first data is arranged on one axis and a plurality of values of the respective items is arranged in a direction orthogonal to the axis, a graph image in which corresponding values are connected by lines over the plurality of items for each group of a plurality of semiconductor chips having the same test environment,
wherein the generating function changes a form of the lines for each group in the graph image according to a ratio of semiconductor chips whose test results have been failed in each group.

According to this computer program, it is possible to realize a computer that supports analysis of a factor when the semiconductor chips whose test results are fail are generated. For example, in the graph image, in a case where lines of groups in which the ratio of semiconductor chips whose test results have been fail is high are concentrated on a specific value of a specific item, the item can be estimated as a factor having a high influence on the fail.

### INDUSTRIAL APPLICABILITY

The technology of the present disclosure can be applied to a device that analyzes a test result of a semiconductor chip.

### REFERENCE SIGNS LIST

10 analysis system, 16 analysis device, 30 condition data acquirer, 32 test result acquirer, 34 decision tree generator, 38 graph generator, 40 analysis result outputter

## Claims

1. A semiconductor test result analysis device comprising:
- a first acquirer structured to acquire first data of a plurality of items related to a test process of a plurality of semiconductor chips;
- a second acquirer structured to acquire second data indicating test results of the plurality of semiconductor chips in the test process;
- a decision tree generator structured to generate a decision tree with each item of the first data as a feature amount and the second data as a target value; and
- an outputter structured to output, as an item having a large influence on the test results, information of a feature amount having a relatively high importance in the decision tree.

2. The semiconductor test result analysis device according to claim 1,
wherein the first data includes an item whose value is a discrete value.

3. The semiconductor test result analysis device according to claim 1 or 2, wherein the first data includes at least one of (1) a pushing amount of a probe card into each of the semiconductor chips, (2) a jig ID, (3) an ID of an operator in charge of a test, (4) an ID of a semiconductor test device, (5) a lot ID of each of the semiconductor chips, (6) coordinates of each of the semiconductor chips on a wafer, and (7) the number of tests.

4. The semiconductor test result analysis device according to any one of claims 1 to 3,
wherein the second data indicates pass/fail for each category determined in advance as the test results, the decision tree generator generates a decision tree for each category, and the outputter outputs information of a feature amount having a relatively high importance in the decision tree for each category.

5. The semiconductor test result analysis device according to any one of claims 1 to 4,
wherein the outputter outputs information based on accuracy of classification by the decision tree together with the information of a feature amount having a relatively high importance in the decision tree.

6. A semiconductor test result analysis method comprising:
- a step of causing a computer to acquire first data of a plurality of items related to a test process of a plurality of semiconductor chips;
- a step of causing the computer to acquire second data indicating test results of the plurality of semiconductor chips in the test process;
- a step of causing the computer to generate a decision tree with each item of the first data as a feature amount and the second data as a target value; and
- a step of causing the computer to output, as an item having a large influence on the test results, information of a feature amount having a relatively high importance in the decision tree.

7. A computer program for causing a computer to realize:
- a function of acquiring first data of a plurality of items related to a test process of a plurality of semiconductor chips;
- a function of acquiring second data indicating test results of the plurality of semiconductor chips in the test process;
- a function of generating a decision tree with each item of the first data as a feature amount and the second data as a target value; and
- a function of outputting, as an item having a large influence on the test results, information of a feature amount having a relatively high importance in the decision tree.
